# EUROPEAN PATENT APPLICATION

(11) **EP 2 068 443 A1**
(43) Date of publication of application: **10.06.2009**
(21) Application number: 07791867.0
(22) Date of filing: 02.08.2007
(51) Int. Cl.: H03H 9/64, H01L 41/09, H01L 41/18, H03H 9/145, H03H 9/25

(54) **BOUNDARY ACOUSTIC WAVE FILTER**

(30) Priority: 25.09.2006 JP 2006259022
(71) Applicant: Murata Manufacturing Co. Ltd., Nagaokakyo-shi, Kyoto 617-8555 (JP)
(72) Inventor: MUKAI, Takao, c/o (A170) IP Department, Nagaokakyo-shi, Kyoto-fu 617-8555 (JP); YATA, Masaru, c/o (A170) IP Department, Nagaokakyo-shi, Kyoto-fu 617-8555 (JP); FUJII, Yasuhisa, c/o (A170) IP Department, Nagaokakyo-shi, Kyoto-fu 617-8555 (JP)
(74) Representative: Thévenet, Jean-Bruno
(86) International application number: PCT/JP2007/065193
(87) International publication number: WO 2008/038459

(57) **Abstract**

A boundary acoustic wave filter device that is able to reduce an insertion loss within a pass band is provided. A longitudinally coupled resonator boundary acoustic wave filter device 100 includes: a piezoelectric substance made of LiNbO₃ having a principal plane obtained by rotating the Y-axis through 15 degrees +-10 degrees; a dielectric substance made of silicon oxide and laminated on the piezoelectric substance; and an electrode structure arranged at a boundary between the piezoelectric substance and the dielectric substance. The electrode structure includes: a plurality of IDTs 112 to 114, 122 to 124, 132 to 134, 142 to 144, 152 to 154, and 162 to 164, arranged in a direction in which a boundary acoustic wave propagates; and reflectors 111, 115, 121, 125, 131, 135, 141, 145, 151, 155, 161 and 165, and wherein where in each of the plurality of IDTs, the overlap width of electrode fingers is W and the interval of electrode fingers is P, 20 ≤ W/P ≤ 45 is satisfied.

## Description

### TECHNICAL FIELD

The present invention relates to a boundary acoustic wave filter device used as, for example, a band-pass filter of a cellular phone, and, more particularly, to a longitudinally coupled resonator boundary acoustic wave filter device.

### BACKGROUND ART

Various surface acoustic wave filter devices are used as a band-pass filter of a cellular phone, or the like.

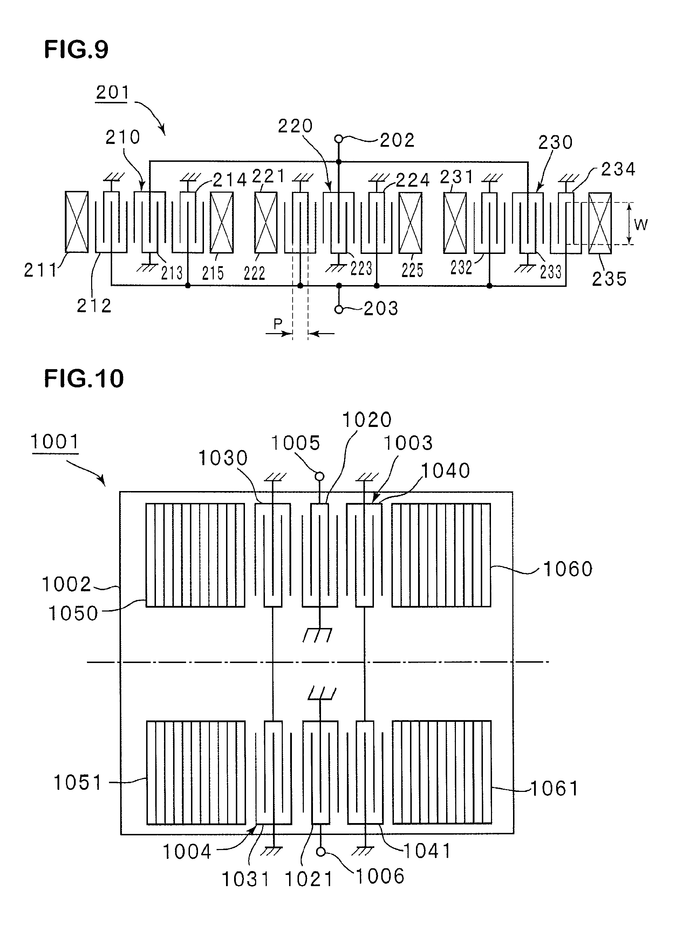

For example, the following Patent Document 1 describes a longitudinally coupled resonator surface acoustic wave filter device used for application of this type. FIG. 10 is a schematic plan view that shows a surface acoustic wave filter device described in Patent Document 1. The surface acoustic wave filter device 1001 includes a piezoelectric substrate 1002 made of 36 degrees rotated Y-cut X-propagating LiTaO₃.

First and second longitudinally coupled resonator surface acoustic wave filter portions 1003 and 1004 are formed on the piezoelectric substrate 1002.

The first longitudinally coupled resonator surface acoustic wave filter portion 1003 has a first IDT 1020, and second and third IDTs 1030 and 1040. The first IDT 1020 is arranged in the middle. The second and third IDTs 1030 and 1040 are arranged respectively on both sides of the first IDT 1020 in a surface acoustic wave propagating direction in which a surface acoustic wave propagates. Reflectors 1050 and 1060 are arranged respectively on both sides of the region, in which the IDTs 1020 to 1040 are provided, in the surface acoustic wave propagating direction. The middle first IDT 1020 is connected to an input terminal 1005, and the other end thereof is connected to ground.

One ends of the IDTs 1030 and 1040 at both sides are connected to ground, and the other ends thereof are connected to one end of second and third IDTs 1031 and 1041 of the second longitudinally coupled resonator surface acoustic wave filter portion 1004.

The other ends of the IDTs 1031 and 1041 are connected to ground.

The second longitudinally coupled resonator surface acoustic wave filter portion 1004 is also a three-IDT type longitudinally coupled resonator surface acoustic wave filter portion, and has a first IDT 1021 in the middle thereof. One end of the IDT 1021 is connected to ground, and the other end thereof is connected to an output terminal 1006. Reflectors 1051 and 1061 are arranged respectively on both side of the portion at which the IDTs 1021 to 1041 are provided.

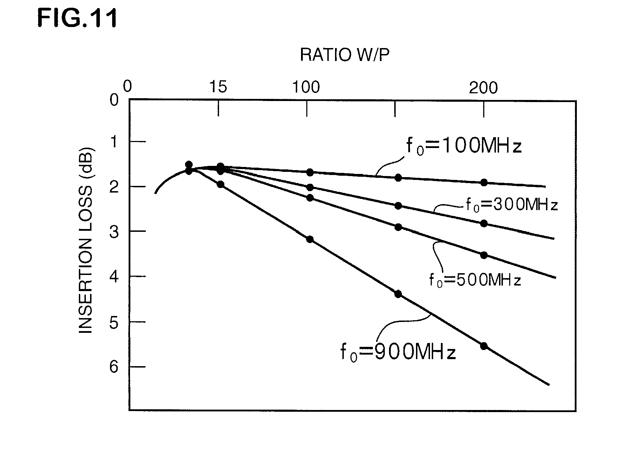

In the longitudinally coupled resonator surface acoustic wave filter device 1001, it is described that where the overlap width of each of the IDTs 1020 to 1040, 1021 to 1041 is W, and the pitch of the electrode fingers is P, the ratio W/P desirably ranges from 15 to 90. That is, FIG. 11 shows that, as the ratio W/P increases, an insertion loss tends to increase irrespective of a center frequency. In addition, when the ratio W/P is smaller than 15, an insertion loss abruptly increases irrespective of a center frequency. Patent Document 1 describes that an insertion loss may be reduced by setting the lower limit of the ratio W/P to 15 and the upper limit of the ratio W/P to 90. Then, by setting W/P to be larger than or equal to 15 and to be smaller than or equal to 90, insertion losses in the center frequencies may be smaller than or equal to 3 dB.

On the other hand, the following Patent Document 2 describes a one-port boundary acoustic wave resonator that is formed so that an electrode having IDTs is formed at a boundary between a piezoelectric substrate made of 36 degrees rotated Y-cut X-propagating LiTaO₃ and an SiO₂ film. In the description made with reference to FIG. 4 of Patent Document 2, the structure that the aperture length of the IDT is 15λ and the interval λ of the IDT is 4 µm in the one-port boundary acoustic wave resonator is described. Note that the aperture length corresponds to a value obtained by adding the overlap width of the IDT and the sum of gap sizes between the overlap portion and the bus bars.
Patent Document 1: Japanese Unexamined Patent Application Publication No. 5-335881
Patent Document 2: WO98/52279

### DISCLOSURE OF INVENTION

As described above, Patent Document 1 describes that in a longitudinally coupled resonator surface acoustic wave filter device that uses a 36 degrees rotated Y-cut X-propagating LiTaO₃ substrate, when the ratio W/P ranges from 15 to 90, an insertion loss may be reduced.

On the other hand, in a band-pass filter, or the like, used in an RF stage of a cellular phone, a low loss is strongly required. For example, when used as an RX band-pass filter of GSM 800 MHz band or GSM 1900 MHz band, an insertion loss of the pass band is required to be 2.5 dB or below. Thus, a filter device needs to be designed to satisfy such low-loss requirement. However, design parameters and values that achieve such a low loss are different between a surface acoustic wave filter device and a boundary acoustic wave filter device. Thus, even when the results of the surface acoustic wave filter device described in Patent Document 1 are applied directly to the boundary acoustic wave filter device, an insertion loss may not be 2.5 dB or below.

On the other hand, Patent Document 2 describes that in a boundary acoustic wave filter device that uses 36 degrees rotated Y-cut X-propagating LiTaO₃ substrate, when the aperture length is set to 15λ, a favorable characteristic may be obtained.

The inventors of the present application studied the disclosure of the above described related arts and found that in a longitudinally coupled resonator boundary acoustic wave filter device that uses a piezoelectric substrate made of LiNbO₃ having a principal plane obtained by rotating the Y-axis through 15 degrees +-10 degrees, the aperture length is set to 15λ; however, lateral leakage increases and a reduction in insertion loss cannot be achieved.

In view of the current level of the existing arts described above, It is an object of the invention to provide a longitudinally coupled resonator boundary acoustic wave filter device that uses a LiNbO₃ substrate having a principal plane obtained by rotating the Y-axis through 15 degrees +-10 degrees and that is able to reduce an insertion loss.

According to a first invention of the present application, a boundary acoustic wave filter device includes: a piezoelectric substance made of LiNbO₃ having a principal plane obtained by rotating the Y-axis through 15 degrees +-10 degrees; a dielectric substance made of silicon oxide and laminated on the piezoelectric substance; and an electrode structure arranged at a boundary between the piezoelectric substance and the dielectric substance, wherein the boundary acoustic wave filter device utilizes a boundary acoustic wave that propagates along the boundary, wherein the electrode structure forms a longitudinally coupled resonator boundary acoustic wave filter portion that includes: a plurality of IDTs arranged in a boundary acoustic wave propagating direction in which the boundary acoustic wave propagates; and a pair of reflectors arranged respectively on both sides of a region, in which the plurality of IDTs are provided, in the boundary acoustic wave propagating direction, and wherein where in each of the plurality of IDTs, the overlap width of electrode fingers is W and the interval of electrode fingers is P, 20 ≤ W/P ≤ 45 is satisfied.

According to a second invention, a boundary acoustic wave filter device includes: a piezoelectric substance made of LiNbO₃ having a principal plane obtained by rotating the Y-axis through 15 degrees +-10 degrees; and a dielectric substance made of silicon oxide and laminated on the piezoelectric substance, wherein the electrode structure forms N (N is integer larger than or equal to 3) longitudinally coupled resonator boundary acoustic wave filter portions, each of which includes: three IDTs arranged in a boundary acoustic wave propagating direction in which the boundary acoustic wave propagates; and a pair of reflectors arranged respectively on both sides of a region, in which the three IDTs are provided, in the boundary acoustic wave propagating direction, and wherein the electrode structure further includes an input terminal and an output terminal, input ends of the N longitudinally coupled resonator boundary acoustic wave filter portions are connected to the input terminal, and where in each of the IDTs, the overlap width of electrode fingers is W and the interval of electrode fingers is P, 20 ≤ W/P ≤ 45 is satisfied.

According to a third invention, a boundary acoustic wave filter device includes: a piezoelectric substance made of LiNbO₃ having a principal plane obtained by rotating the Y-axis through 15 degrees +-10 degrees; a dielectric substance made of silicon oxide and laminated on the piezoelectric substance; and an electrode structure arranged at a boundary between the piezoelectric substance and the dielectric substance, wherein the boundary acoustic wave filter device utilizes a boundary acoustic wave that propagates along the boundary, wherein the electrode structure forms first to sixth longitudinally coupled resonator boundary acoustic wave filter portions, each of which includes first to third IDTs arranged in the boundary acoustic wave propagating direction in which the boundary acoustic wave propagates, wherein the electrode structure includes: an unbalanced terminal to which input ends of the first to sixth longitudinally coupled resonator boundary acoustic wave filter portions are connected; a first balanced terminal to which output ends of the first to third longitudinally coupled resonator boundary acoustic wave filter portions are connected; and a second balanced terminal to which output ends of the fourth to sixth longitudinally coupled resonator boundary acoustic wave filter portions are connected, wherein the phase of an output signal to an input signal is the same in each of the first to third longitudinally coupled resonator boundary acoustic wave filter portion, and the phase of an output signal to an input signal is the same in each of the fourth to sixth longitudinally coupled resonator boundary acoustic wave filter, wherein the phase of an output signal to an input signal in each of the first to third longitudinally coupled resonator boundary acoustic wave filter portions is varied by 180 degrees from the phase of an output signal to an input signal in each of the fourth to sixth longitudinally coupled resonator boundary acoustic wave filter portions, and wherein where in each of the IDTs, the overlap width of electrode fingers is W and the interval of electrode fingers is P, 20 ≤ W/P ≤ 45 is satisfied.

In the first to third inventions, preferably, the ratio W/P is in a range of 22 ≤ W/P ≤ 32. By so doing, it is possible to further reduce an insertion low loss.

In the invention, preferably, each IDT is formed of a metal thin film, the metallization ratio of each IDT is 0.45 or below, and where the density of the metal thin film is p (g/cm³), the thickness of an electrode is h (µm) and the interval of electrode fingers is P (µm), p×h/P ≥ 1.2 (g/cm³) is satisfied. In this case, it is possible to further reduce an insertion loss.

### (Advantages)

In the boundary acoustic wave filter device according to the first invention, an electrode structure that forms a longitudinally coupled resonator boundary acoustic wave filter portion is formed at a boundary between a piezoelectric substance made of LiNbO₃ having a principal plane obtained by rotating the Y-axis through 15 degrees +-10 degrees and a dielectric substance made of SiO₂, and in the IDTs of the electrode structure, the ratio W/P ranges from 20 to 45. Thus, it is possible to reduce an insertion loss within the pass band.

Similarly, in the second invention as well, N (N is integer larger than or equal to 3) longitudinally coupled resonator boundary acoustic wave filter portions are formed at a boundary between a piezoelectric substance made of LiNbO₃ having a principal plane obtained by rotating the Y-axis through 15 degrees +-10 degrees and a dielectric substance made of SiO₂, and in the IDTs of each of the longitudinally coupled resonator boundary acoustic wave filter portions, W/P ranges from 20 to 45. Thus, it is possible to reduce an insertion loss. In addition, because input ends of the N longitudinally coupled resonator boundary acoustic wave filter portions are connected to a signal input terminal, power withstanding capability is enhanced.

In the third invention as well, an electrode structure that forms first to sixth longitudinally coupled resonator boundary acoustic wave filter portions is formed at a boundary between a piezoelectric substance made of LiNbO₃ having a principal plane obtained by rotating the Y-axis through 15 degrees +-10 degrees and a dielectric substance made of SiO₂, and in the IDTs of these longitudinally coupled resonator boundary acoustic wave filter portions, W/P ranges from 20 to 45. Thus, it is possible to reduce an insertion loss.

In addition, in the third invention, the input ends of the first to sixth longitudinally coupled resonator boundary acoustic wave filter portions are connected to the unbalanced terminal, the output ends of the first to third longitudinally coupled resonator boundary acoustic wave filter portions are connected to the first balanced terminal, and the output ends of the fourth to sixth longitudinally coupled resonator boundary acoustic wave filter portions are connected to the second balanced terminal. Thus, it is possible to provide a boundary acoustic wave filter device having a balance-unbalance converter function.

### BRIEF DESCRIPTION OF DRAWINGS

[FIG. 1] FIG. 1 is a schematic plan view that shows the electrode structure of a boundary acoustic wave filter device according to a first embodiment of the invention.
[FIG. 2] FIG. 2 is a schematic front cross-sectional view of the boundary acoustic wave filter device according to the first embodiment of the invention.
[FIG. 3] FIG. 3 is a view that shows a variation in filter characteristic when the ratio W/P is varied in the boundary acoustic wave filter device of the present embodiment.
[FIG. 4] FIG. 4 is a view that shows the relationship between a ratio W/P and an insertion loss.
[FIG. 5] FIG. 5 is a view that shows the filter characteristic of a boundary acoustic wave filter device of an embodiment having a three-element parallel structure and the filter characteristic of a boundary acoustic wave filter device of an embodiment having a two-element parallel structure.
[FIG. 6] FIG. 6(a) to FIG. 6(c) are views that show filter characteristics when the product of IDT density and normalized thickness (ρ×h/P) is 1.0 g/cm³ and the metallization ratios are 0.40, 0.45 and 0.5, respectively.
[FIG. 7] FIG. 7(a) to FIG. 7(c) are views that show filter characteristics when the product of IDT density and normalized thickness (ρ×h/P) is 1.2 g/cm³ and the metallization ratios are 0.40, 0.45 and 0.5, respectively.
[FIG. 8] FIG. 8(a) to FIG. 8(c) are views that show filter characteristics when the product of IDT density and normalized thickness (ρ×h/P) is 1.4 g/cm³ and the metallization ratios are 0.40, 0.45 and 0.5, respectively.
[FIG. 9] FIG. 9 is a schematic plan view that shows the electrode structure of a boundary acoustic wave filter device according to a second embodiment of the invention.
[FIG. 10] FIG. 10 is a plan view that shows an existing surface acoustic wave filter device.
[FIG. 11] FIG. 11 is a view that shows the relationship between a ratio W/P and an insertion loss in the existing surface acoustic wave filter device.

### REFERENCE NUMERALS

- 100: boundary acoustic wave filter device
- 101: unbalanced terminal
- 102, 103: first and second balanced terminals
- 110, 120, and 130: first to third longitudinally coupled resonator boundary acoustic wave filter portions
- 111, 121, 131: reflector
- 112, 122, 132: second IDT
- 113, 123, 133: first IDT
- 114, 124, 134: third IDT
- 115, 125, 135: reflector
- 140 to 160: fourth to sixth longitudinally coupled resonator boundary acoustic wave filter portions
- 141, 151, 161: reflector
- 142, 152, 162: second IDT
- 143, 153, 163: first IDT
- 144, 154, 164: third IDT
- 145, 155, 165: reflector
- 171, 172: boundary acoustic wave resonator
- 181 to 184: boundary acoustic wave resonator
- 104: piezoelectric substance
- 105: SiO₂ film
- 105a, 105b: opening
- 106: electrode structure
- 107a, 107b: conductive pattern
- 108a, 108b: external electrode
- 201: boundary acoustic wave filter device
- 202: input terminal
- 203: output terminal
- 210, 220, 230: first to third longitudinally coupled resonator boundary acoustic wave filter portions
- 211, 211, 231: reflector
- 212, 222, 232: second IDT
- 213, 223, 233: first IDT
- 214, 224, 234: third IDT
- 215, 225, 235: reflector

### BEST MODES FOR CARRYING OUT THE INVENTION

Hereinafter, embodiments of the invention will be described with reference to the accompanying drawings to clarify the invention.

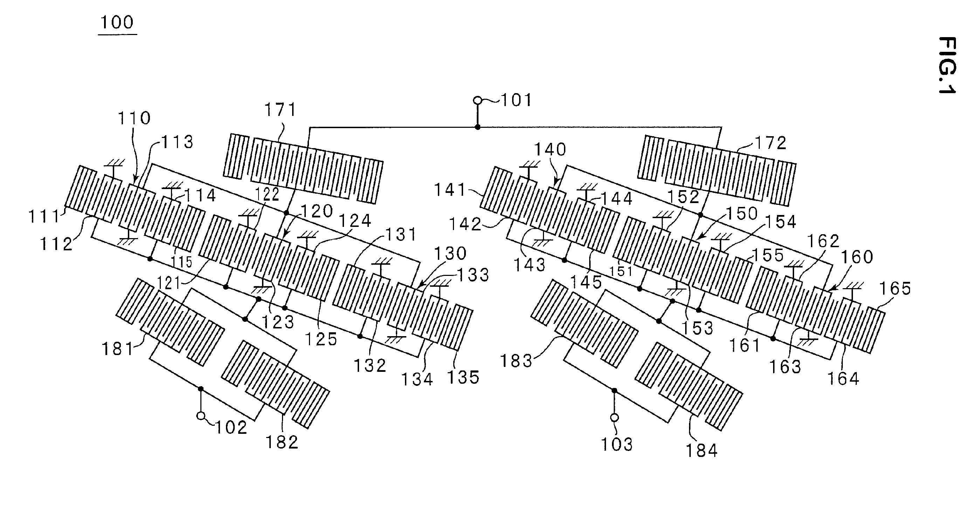

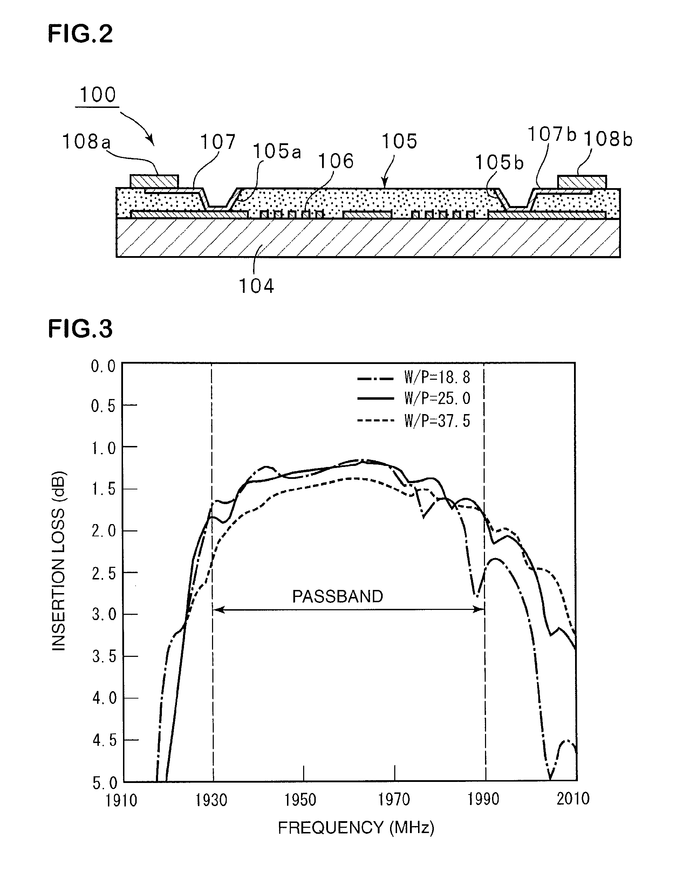

FIG. 1 is a schematic plan view that shows the electrode structure of a boundary acoustic wave filter device according to a first embodiment of the invention. FIG. 2 is a schematic front cross-sectional view of the boundary acoustic wave filter device according to the first embodiment of the invention.

The boundary acoustic wave filter device 100 of the present embodiment is a band-pass filter of a receiving band of GSM 1900 MHz. A receiving side band-pass filter used in an RF stage of the cellular phone has a pass band of 1930 to 1990 MHz. 2.5 dB or below insertion loss is required within the above pass band.

The boundary acoustic wave filter device 100 is formed of a piezoelectric substance made of LiNbO₃ having a principal plane obtained by rotating the Y-axis through 15 degrees +-10 degrees. That is, the piezoelectric substance defined by Euler angles (φ, θ, ψ) equal to φ = 0 degrees and θ = 105 degrees +-10 degrees is used.

An SiO₂ film, as silicon oxide, is laminated on the piezoelectric substance to thereby form a longitudinally coupled resonator boundary acoustic wave filter device that uses an SH-type boundary acoustic wave propagating along a boundary between the piezoelectric substance and the SiO₂ film.

More specifically, as shown in FIG. 1, the electrode structure shown in the drawing is formed between an unbalanced terminal 101 and first and second balanced terminals 102 and 103.

As shown in FIG. 2, in the boundary acoustic wave filter device 100, an SiO₂ film 105 is formed on the piezoelectric substance 104. Then, the electrode structure 106 is provided at a boundary therebetween. In addition, openings 105a and 105b are provided in the SiO₂ film 105. Portions that are electrically connected to the outside of the electrode structure 106 are exposed through the openings 105a and 105b. Conductive patterns 107a and 107b are formed in the openings 105a and 105b. The conductive patterns 107a and 107b are electrically connected to the electrode structure 106 in the openings and extend outside of the openings 105a and 105b, respectively. Then, external electrodes 108a and 108b are formed on the upper face of the SiO₂ film 105. The external electrodes 108a and 108b are electrically connected to the conductive patterns 107a and 107b, respectively. The external electrodes 108a and 108b correspond to the above described unbalanced terminal 101, first and second balanced terminals 102 and 103, portions connected to ground, which will be described later.

Note that in the present embodiment, the dielectric substance is formed of the SiO₂ film 105; instead, the dielectric substance may be formed of silicon oxide other than SiO₂.

The electrode structure shown in FIG. 1 is formed as the electrode structure 106. That is, input ends of first to third longitudinally coupled resonator boundary acoustic wave filter portions 110, 120 and 130 are connected in common to the unbalanced terminal 101. The first to third longitudinally coupled resonator boundary acoustic wave filter portions 110 to 130 each are a three-IDT type longitudinally coupled resonator boundary acoustic wave filter portion, and respectively include first IDTs 113, 123 and 133, arranged in the middle, and second IDTs 112, 122 and 132 and third IDTs 114, 124 and 134, arranged on both sides of the first IDTs 113, 123 and 133 in a boundary acoustic wave propagating direction in which a boundary acoustic wave propagates. In addition, the longitudinally coupled resonator boundary acoustic wave filter portions 110, 120 and 130 respectively include pairs of reflectors 111 and 115, 121 and 125, and 131 and 135, which are arranged respectively on both sides of the regions, in which three IDTs are provided, in the boundary acoustic wave propagating direction.

One ends of the middle first IDTs 113, 123 and 133 of the first to third longitudinally coupled resonator boundary acoustic wave filter portions are connected in common to the unbalanced terminal 101 via a one-port boundary acoustic wave resonator 171. The one-port boundary acoustic wave resonator 171 includes an IDT and reflectors arranged respectively on both sides of the IDT in the boundary wave propagating direction.

One ends of the second IDTs 112, 122 and 132 and third IDTs 114, 124 and 134 of the first to third longitudinally coupled resonator boundary acoustic wave filter portions 110, 120 and 130 are connected to ground, and the other ends are connected in common to a first balanced terminal 102 via one-port boundary acoustic wave resonators 181 and 182. The one-port boundary acoustic wave resonators 181 and 182 each include an IDT and reflectors arranged respectively on both sides of the IDT in the boundary wave propagating direction. Here, the one-port boundary acoustic wave resonator 181 and the one-port boundary acoustic wave resonator 182 are connected in parallel with each other.

Among the first to third longitudinally coupled resonator boundary acoustic wave filter portions, the phase of an output signal to an input signal is the same.

On the other hand, input ends of fourth to sixth longitudinally coupled resonator boundary acoustic wave filter portions 140, 150 and 160 are connected in common to the unbalanced terminal 101 via a one-port boundary acoustic wave resonator 172. The one-port boundary acoustic wave resonator 172 is formed in a similar manner to the one-port boundary acoustic wave resonator 171. In addition, the fourth to sixth longitudinally coupled resonator boundary acoustic wave filter portions 140 to 160 respectively include first IDTs 143, 153 and 163, second and third IDTs 142, 144, 152, 154, 162 and 164, arranged on both sides of the first IDTs, and reflectors 141, 145, 151, 155, 161, and 165.

Among the forth to sixth longitudinally coupled resonator boundary acoustic wave filter portions, the phase of an output signal to an input signal is the same.

However, the phase of an output signal to an input signal in each of the fourth to sixth longitudinally coupled resonator boundary acoustic wave filter portions is different by 180 degrees from the phase of an output signal to an input signal in each of the first to third longitudinally coupled resonator boundary acoustic wave filter portions 110, 120 and 130. To obtain the above phase relationship, the polarity of each of the first IDTs 143, 153 and 163 of the fourth to sixth longitudinally coupled resonator boundary acoustic wave filter portions 140 to 160 is inverted against the polarity of each of the first IDTs 113, 123 and 133 of the first to third longitudinally coupled resonator boundary acoustic wave filter portions 110, 120 and 130. Other than the above, the fourth to sixth longitudinally coupled resonator boundary acoustic wave filter portions 140 to 160 are formed similarly to the first to third longitudinally coupled resonator boundary acoustic wave filter portions 110 to 130.

One ends of the second and third IDTs 142, 144, 152, 154, 162 and 164 of the fourth to sixth longitudinally coupled resonator boundary acoustic wave filter portions 140 to 160 are connected to ground, and the other ends are connected in common to a second balanced terminal 103 via boundary acoustic wave resonators 183 and 184. The one-port boundary acoustic wave resonators 183 and 184 are connected in parallel with each other.

In the longitudinally coupled resonator boundary acoustic wave filter device of the present embodiment, as described above, the first to third longitudinally coupled resonator boundary acoustic wave filter portions 110 to 130 are connected in common between the unbalanced terminal 101 and the first balanced terminal 102, and the fourth to sixth longitudinally coupled resonator boundary acoustic wave filter portions 140 to 160 are connected in common between the unbalanced terminal 101 and the second balanced terminal 103, to thereby form a filter device having a balance-unbalance converter function. Then, because the first to sixth longitudinally coupled resonator boundary acoustic wave filter portions 110 to 160 are connected in parallel and then connected to the unbalanced terminal 101, it is possible to enhance power withstanding capability.

Note that in the present embodiment, the boundary acoustic wave propagating direction in the first to sixth longitudinally coupled resonator boundary acoustic wave filter portions 110 to 160 is ψ = 20°, the boundary acoustic wave propagating direction in the boundary acoustic wave resonators 171 and 172 is ψ = 10°, and the boundary acoustic wave propagating direction in the boundary acoustic wave resonators 181 to 184 is ψ = 30°. That is, by varying these boundary acoustic wave propagating directions, the electromechanical coupling factor of each element is set to an appropriate value. Thus, it is possible to obtain a favorable characteristic.

However, the boundary wave propagating direction of each of the longitudinally coupled resonator boundary acoustic wave filter portions 110 to 160 may be set to the same direction as the boundary wave propagating direction of each of the boundary acoustic wave resonators 171, 172, 181 to 184.

The longitudinally coupled resonator boundary acoustic wave filter device 100 of the present embodiment has such a feature that in the first to sixth longitudinally coupled resonator boundary acoustic wave filter portions 110 to 160, where the overlap width of the electrode fingers of each IDT is W and the interval of the electrode fingers is P, the ratio W/P ranges from 20 to 45, more preferably, from 22 to 32. By so doing, it is possible to remarkably reduce an insertion loss. This will be more specifically described.

The longitudinally coupled resonator boundary acoustic wave filter devices of the present embodiment having different ratios W/P were manufactured. In this case, the LiNbO₃ substrate used LiNbO₃ having a principal plane obtained by rotating the Y-axis through 15 degrees, and the SiO₂ film 105 had a thickness of 10 µm. In addition, the electrode structure used a metal layer made of Au, and the metal layer had a thickness of 0.05P.

Three boundary acoustic wave filter devices were formed so that, in the longitudinally coupled resonator boundary acoustic wave filter portions 110 to 160, the metallization ratio of each IDT was 0.4, W/Ps were respectively 18.8, 25.0 and 37.5. Note that the interval of the electrode fingers of the boundary acoustic wave resonator 172 was varied by 0.004 µm from the interval of the electrode fingers of the boundary acoustic wave resonator 171 to thereby improve balancing.

FIG. 3 is a view that shows the filter characteristics of three boundary acoustic wave filter devices manufactured as described above. As is apparent from FIG. 3, when the ratio W/P is 18.8, a large ripple appeared around 1988 MHz, and an insertion loss is large and about 2.9 dB. In addition, a relatively large ripple appeared around 1974 MHz.

In contrast, it shows that when W/P is 25.0 or 37.5, a maximum insertion loss may be 2.5 dB or below within the pass band, that is, in the frequency range of 1930 to 1990 MHz. Thus, FIG. 3 shows that when the overlap width W/P is larger than or equal to 25, an insertion loss within the pass band may be remarkably reduced.

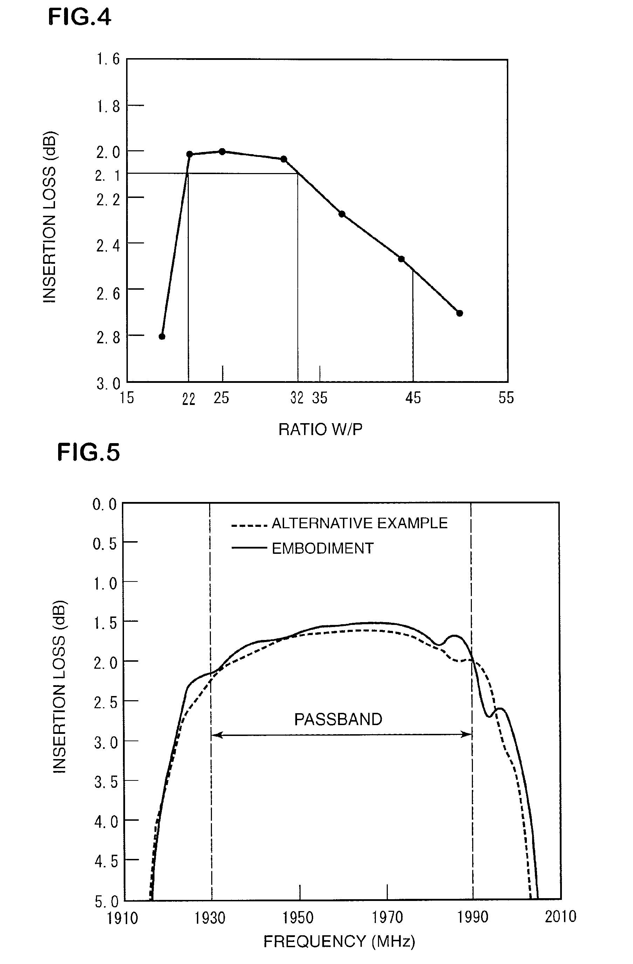

Next, in the boundary acoustic wave filter device of the embodiment, the ratio W/P was variously changed, and an insertion loss within the pass band was measured as in the above described manner. The results are shown in FIG. 4.

As is apparent from FIG. 4, when the ratio W/P ranges from 20 to 45, an insertion loss within the pass band may be 2.5 dB or below. Thus, the ratio W/P is required to range from 20 to 45. In addition, FIG. 4 shows that, preferably, when the ratio W/P ranges from 22 to 32, an insertion loss may be further reduced and to 2.1 dB or below. Thus, the ratio W/P more desirably ranges from 22 to 32.

In the first embodiment, the total number of pairs of electrode fingers in each of the first to third IDTs ranges from 20 pairs to 40 pairs. When the total number of pairs of electrode fingers of each of a plurality of IDTs in each longitudinally coupled resonator boundary acoustic wave filter portion is small and ranges from about 20 pairs to about 40 pairs, the above described lateral leakage tends to increase. Thus, when the total number of pairs of electrode fingers of a plurality of IDTs is relatively small in the boundary acoustic wave filter device, advantageous effect obtained by reducing an insertion loss owing to W/P ranging from 20 to 45 is relatively large.

Note that in the boundary acoustic wave filter device 100 of the embodiment shown in FIG. 1, the first to third longitudinally coupled resonator boundary acoustic wave filter portions 110 to 130, that is, three longitudinally coupled resonator boundary acoustic wave filter portions, are connected in parallel between the unbalanced terminal 101 and the first balanced terminal 102, and similarly, three longitudinally coupled resonator boundary acoustic wave filter portions 140 to 160 are connected between the unbalanced terminal 101 and the second balanced terminal 103.

However, it is not limited to the structure that the three longitudinally coupled resonator boundary acoustic wave filter portions are connected in parallel with one another as described above. Instead, in FIG. 1, it is applicable that, for example, the longitudinally coupled resonator boundary acoustic wave filter portions 130 and 160 are omitted, and two longitudinally coupled resonator boundary acoustic wave filter portions are respectively connected in parallel between the unbalanced terminal 101 and the first balanced terminal 102 and between the unbalanced terminal 101 and the second balanced terminal 103. The above boundary acoustic wave filter device according to an alternative example was manufactured and its filter characteristic was measured. The results are shown in FIG. 5.

FIG. 5 shows a filter characteristic when in the boundary acoustic wave filter device 102 of the embodiment, the overlap width W is set to 40 µm and W/P is set to 25. On the other hand, the broken line shows a filter characteristic when in the alternative example, that is, in the boundary acoustic wave filter device having a two-element parallel structure, the overlap width W is set to 60 µm and W/P is set to 37.5. Note that the reason why W is set to 60 µm in the alternative example is because the overlap width W is set to one and half times the W (=40 µm) in the three-element parallel structure.

As is apparent from FIG. 5, in comparison with the two-element parallel structure, in the three-element parallel structure of the embodiment, it is possible to reduce the overlap width W of each electrode finger to thereby reduce a loss due to the resistance of the electrode finger. By so doing, it is possible to reduce an insertion loss. Thus, in the invention, in a structure that input ends of N (N is integer larger than or equal to 3) longitudinally coupled resonator boundary acoustic wave filter portions are connected to the input terminal, N is desirably set to 3 or above. By so doing, it is possible to further reduce an insertion loss.

In addition, the band-pass filter of a GSM 1900 MHz receiving band of a cellular phone is mostly used in a system of which an input impedance is 50 Ω and an output impedance is 150 Ω. In this case, when the boundary acoustic wave filter device 100 of the embodiment is designed so that the metallization ratio of each IDT is set to 0.5, W/P is 17. Note that the metallization ratio is a ratio of the size of the electrode fingers in the width direction in an IDT to the sum of the size of the electrode fingers in the width direction and gaps between the electrode fingers. That is, in order to be used for a 50-150 Ω system, when the metallization ratio is set to 0.5, in the three-element parallel structure boundary acoustic wave filter device 100 of the embodiment, W/P is 17. Thus, it is difficult to reduce an insertion loss. Therefore, when the three-element parallel structure is employed for the above application, in order to attain 22 or above of W/P, the metallization ratio needs to be 0.45 or below.

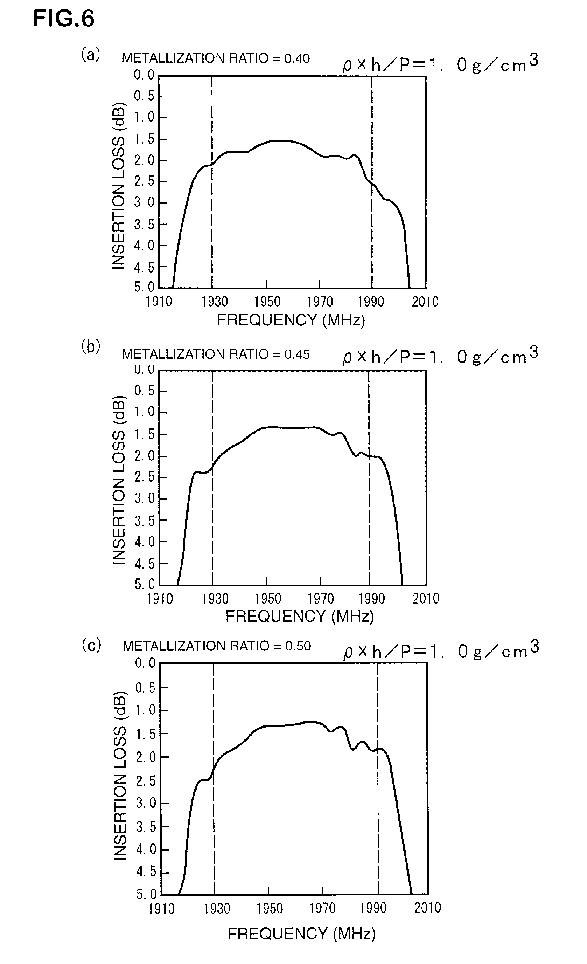

FIG. 6(a) to FIG. 6(c), FIG. 7(a) to FIG. 7(c), and FIG. 8(a) to FIG. 8(c) are views that show filter characteristics of the longitudinally coupled resonator boundary acoustic wave filter device 100 when the thickness of each IDT and the metallization ratio are changed. The IDTs are made of Au. Here, where the density of a metal thin film that forms the IDTs is ρ (g/cm³), the thickness is h (µm), and the interval of electrode fingers is P (µm), the product of the density of metal that forms the IDTs and normalized thickness ρxh/P is used as a parameter. Note that ρ of Au is 19.32 g/cm³. Even when a metal having any density ρ is used, a substantially equivalent filter characteristic may be obtained if ρxh/P is the same.

FIG. 6(a) to FIG. 6(c) show the results when ρxh/P is 1.0 g/cm³ and the metallization rations are respectively 0.40, 0.45 and 0.5.

When Au is formed to have ρxh/P = 1.0 g/cm³, IDTs are made of Au having a thickness-wavelength ratio h/P = 1.0/19.32 = 0.052.

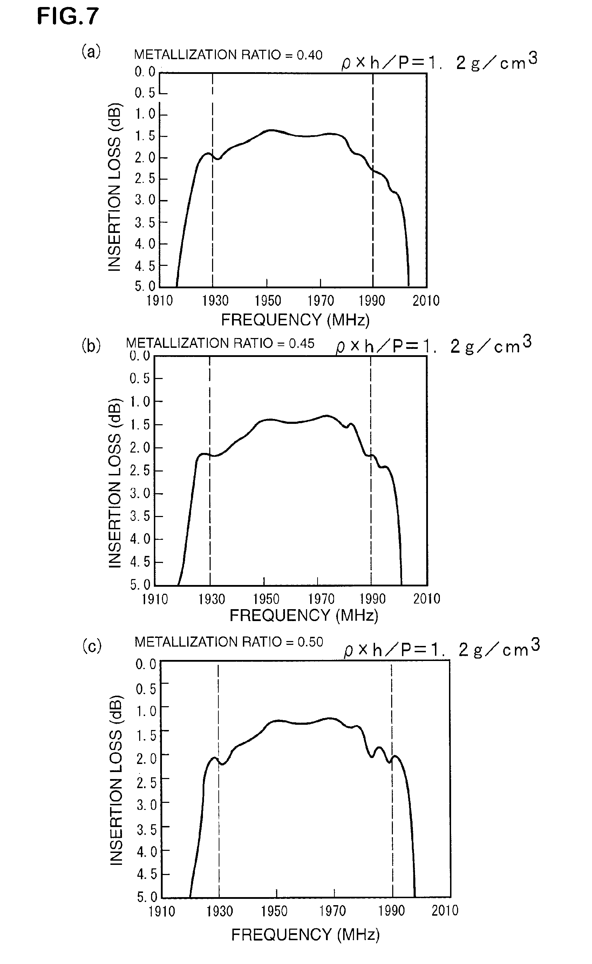

In addition, FIG. 7(a) to FIG. 7(c) show the results when ρxh/P is 1.2 g/cm³ and the metallization ratios are respectively 0.40, 0.45 and 0.5.

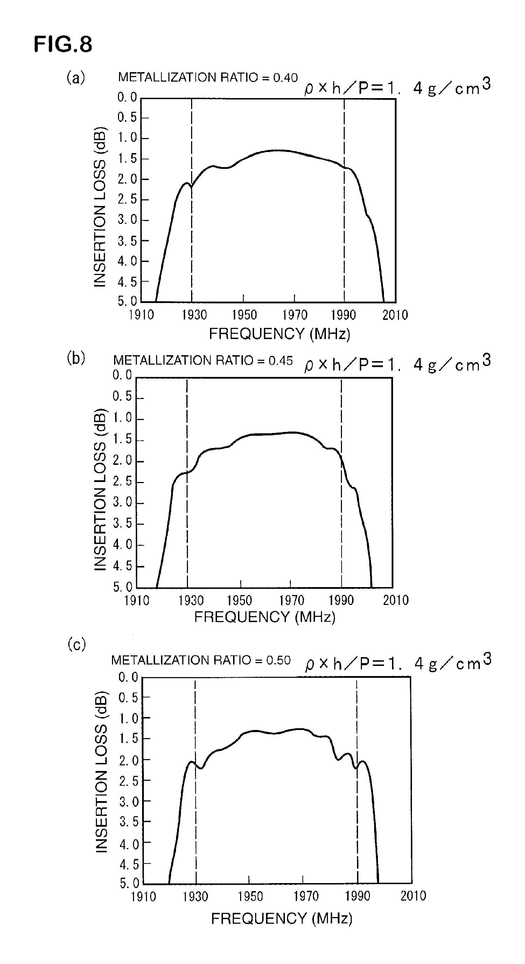

FIG. 8(a) to FIG. 8(c) show the results when ρxh/P is 1.4 g/cm³ and the metallization ratios are respectively 0.40, 0.45 and 0.5.

As is apparent from FIG. 6 to FIG. 8, as the metallization ratio decreases, the insertion loss increases. However, when pxh/P is larger than or equal to 1.2 g/cm³, it appears that degradation of an insertion loss is small when the metallization ratio is 0.45 or below. Thus, in the three-element parallel structure longitudinally coupled resonator boundary acoustic wave filter device, it is desirable that the metallization ratio is 0.45 or below and ρxh/P is 1.2 g/cm³ or above. By so doing, it appears that an insertion loss may be further reduced.

Note that in FIG. 6 to FIG. 8, the characteristics when the metallization ratio is 0.4 or above are shown; however, the metallization ratio may be smaller than 0.4 and, in that case as well, it is possible to obtain favorable filter characteristics having a small ripple. Note that the lower limit of the metallization ratio is not specifically limited for achieving the object of the invention; however, because machining accuracy for electrodes is limited, the lower limit will be determined on the basis of the machining accuracy for electrodes.

In the boundary acoustic wave filter device 100 shown in FIG. 1 and the above described alternative example, the boundary acoustic wave filter device having a balance-unbalance converter function is described; however, the invention is not limited to boundary acoustic wave filter devices having a balance-unbalance converter function. FIG. 9 is a schematic plan view that shows the electrode structure of a boundary acoustic wave filter device according to a second embodiment without having such a balance-unbalance converter function.

In the boundary acoustic wave filter device 201, the electrode structure shown in the drawing is formed between an input terminal 202 and an output terminal 203. One ends of middle first IDTs 213, 223 and 233 of first to third longitudinally coupled resonator boundary acoustic wave filter portions 210, 220 and 230 are connected to the input terminal 202. The other ends of the IDTs 213, 223 and 233 are connected to ground.

Second and third IDTs 212, 214, 222, 224, 232 and 234 are arranged respectively on both side of the first IDTs 213, 223 and 233 in the boundary wave propagating direction. One ends of the second and third IDTs 212, 214, 222, 224, 232 and 234 are connected to ground, and the other ends are connected in common to the output terminal 203.

The longitudinally coupled resonator boundary acoustic wave filter portions 210, 220 and 230 each are a three-IDT type longitudinally coupled resonator boundary acoustic wave filter, as in the case of the above described first longitudinally coupled resonator boundary acoustic wave filter portion 110. The longitudinally coupled resonator boundary acoustic wave filter portions 210, 220 and 230 respectively include pairs of reflectors 211 and 215, 221 and 225, and 231 and 235, which are arranged respectively on both sides of the regions, in which the first to third IDTs are provided, in the boundary wave propagating direction.

In the boundary acoustic wave filter device 201 of the present embodiment as well, where the overlap width of each IDT is W and the interval of electrode fingers is P, when 20 ≤ W/P ≤ 45, preferably, 22 ≤ W/P ≤ 32, is satisfied, it is possible to reduce an insertion loss.

In addition, in the present embodiment as well, by setting the product of the density of metal that forms IDTs and normalized thickness pxh/P to 1.2 g/cm³ or above, it is possible to further reliably reduce an insertion loss.

Note that in FIG. 9, the three longitudinally coupled resonator boundary acoustic wave filter portions 210, 220 and 230 are connected in parallel between the input terminal 202 and the output terminal 203; instead, two longitudinally coupled resonator boundary acoustic wave filter portions may be connected in parallel between the input terminal and the output terminal.

Note that in the above experimental examples, the IDTs are made of Au, but a metal that forms the IDTs is not specifically limited. Instead, the IDTs may be made of another metal such as Cu, Pd or Ag, or may be made of an alloy that is mainly made of these metals, such as Ag-Pd. In addition, the IDTs may be formed of a metal laminated film that is formed by laminating a plurality of metal layers.

## Claims

1. A boundary acoustic wave filter device comprising:
a piezoelectric substance made of LiNbO₃ having a principal plane obtained by rotating the Y-axis through 15 degrees +-10 degrees;
a dielectric substance made of silicon oxide and laminated on the piezoelectric substance; and
an electrode structure arranged at a boundary between the piezoelectric substance and the dielectric substance, wherein the boundary acoustic wave filter device utilizes a boundary acoustic wave that propagates along the boundary, wherein
the electrode structure forms a longitudinally coupled resonator boundary acoustic wave filter portion that includes: a plurality of IDTs arranged in a boundary acoustic wave propagating direction in which the boundary acoustic wave propagates; and a pair of reflectors arranged respectively on both sides of a region, in which the plurality of IDTs are provided, in the boundary acoustic wave propagating direction, and wherein
where in each of the plurality of IDTs, the overlap width of electrode fingers is W and the interval of electrode fingers is P, 20 ≤ W/P ≤ 45 is satisfied.

2. A boundary acoustic wave filter device comprising:
a piezoelectric substance made of LiNbO₃ having a principal plane obtained by rotating the Y-axis through 15 degrees +-10 degrees; and
a dielectric substance made of silicon oxide and laminated on the piezoelectric substance, wherein
the electrode structure forms N (N is integer larger than or equal to 3) longitudinally coupled resonator boundary acoustic wave filter portions, each of which includes: three IDTs arranged in a boundary acoustic wave propagating direction in which the boundary acoustic wave propagates; and a pair of reflectors arranged respectively on both sides of a region, in which the three IDTs are provided, in the boundary acoustic wave propagating direction, and wherein
the electrode structure further includes an input terminal and an output terminal, input ends of the N longitudinally coupled resonator boundary acoustic wave filter portions are connected to the input terminal, and where in each of the IDTs, the overlap width of electrode fingers is W and the interval of electrode fingers is P, 20 ≤ W/P ≤ 45 is satisfied.

3. A boundary acoustic wave filter device comprising:
a piezoelectric substance made of LiNbO₃ having a principal plane obtained by rotating the Y-axis through 15 degrees +-10 degrees;
a dielectric substance made of silicon oxide and laminated on the piezoelectric substance; and
an electrode structure arranged at a boundary between the piezoelectric substance and the dielectric substance, wherein boundary acoustic wave filter device utilizes a boundary acoustic wave that propagates along the boundary, wherein
the electrode structure forms first to sixth longitudinally coupled resonator boundary acoustic wave filter portions, each of which includes first to third IDTs arranged in the boundary acoustic wave propagating direction in which the boundary acoustic wave propagates, wherein
the electrode structure includes: an unbalanced terminal to which input ends of the first to sixth longitudinally coupled resonator boundary acoustic wave filter portions are connected; a first balanced terminal to which output ends of the first to third longitudinally coupled resonator boundary acoustic wave filter portions are connected; and a second balanced terminal to which output ends of the fourth to sixth longitudinally coupled resonator boundary acoustic wave filter portions are connected, wherein
the phase of an output signal to an input signal is the same in each of the first to third longitudinally coupled resonator boundary acoustic wave filter portion, and the phase of an output signal to an input signal is the same in each of the fourth to sixth longitudinally coupled resonator boundary acoustic wave filter, wherein
the phase of an output signal to an input signal in each of the first to third longitudinally coupled resonator boundary acoustic wave filter portions is varied by 180 degrees from the phase of an output signal to an input signal in each of the fourth to sixth longitudinally coupled resonator boundary acoustic wave filter portions, and wherein
where in each of the IDTs, the overlap width of electrode fingers is W and the interval of electrode fingers is P, 20 ≤ W/P ≤ 45 is satisfied.

4. The boundary acoustic wave filter device according to any one of Claims 1 to 3, wherein the ratio W/P is in a range of 22 ≤ W/P ≤ 32.

5. The boundary acoustic wave filter device according to any one of Claims 1 to 4, wherein each IDT is formed of a metal thin film, the metallization ratio of each IDT is 0.45 or below, and where the density of the metal thin film is ρ (g/cm³), the thickness of an electrode is h (µm) and the interval of electrode fingers is P (µm), ρxh/P ≥ 1.2 (g/cm³) is satisfied.
